# EUROPÄISCHE PATENTSCHRIFT

(11) **EP 2 809 019 B1**
(45) Veröffentlichungstag und Bekanntmachung des Hinweises auf die Patenterteilung: **20.01.2016**
(21) Anmeldenummer: 14165952.4
(22) Anmeldetag: 25.04.2014
(51) Int. Cl.: H04B 10/80

(54) **EC-Motor mit dynamischer Bestimmung der Degradation der Optokoppler**
EC motor with dynamic determination of the degradation of the optocoupler
Moteur EC doté d'une détermination dynamique de la dégradation du photo-coupleur

(30) Priorität: 27.05.2013 DE 102013105419
(43) Veröffentlichungstag der Anmeldung: 03.12.2014
(73) Patentinhaber: ebm-papst Mulfingen GmbH & Co. KG, 74673 Mulfingen (DE)
(72) Erfinder: Becker, Eduard, 74653 Ingelfingen (DE); Schmitt, Martin, 97922 Lauda-Königshofen (DE); Hertrich, Alexander, 74677 Dörzbach (DE); Eggensperger, Michael, 74639 Zweiflingen-Friedrichsruhe (DE)
(74) Vertreter: Peter, Julian

(56) Entgegenhaltungen:
- DE-U1- 20 105 050
- US-A1- 2010 109 545
- US-B1- 6 765 361

## Beschreibung

Die vorliegende Erfindung bezieht sich auf einen EC-Motor umfassend eine Motorelektronik, einen Signaleingang oder einen Signalausgang und einen Optokoppler zur galvanisch getrennten Übertragung eines Nutzsignals zwischen der Motorsteuerung und dem Signaleingang oder dem Signalausgang.

Bei EC-Motoren werden Optokoppler zur galvanisch getrennten Signalübertragung der Nutzslgnale für Steuer-, Regel-, oder Überwachungsfunktionen eingesetzt. Die galvanische Trennung dient zum Schutz von Personen und Material und trennt insbesondere die empfindliche Steuerelektronik, an der ein EC-Motor angeschlossen wird, von der Motorelektronik des EC-Motors. Insbesondere bei EC-Motoren für Produkte mit hohen Stückzahlen werden kostengünstige Optokoppler benutzt, bei denen einfache und kostengünstige IC-Strukturen verwendet werden. Diese kostengünstigen Varianten von Optokopplern bestehen aus einem optischen Sender, typischerweise einer Leuchtdiode (LED), und einem optischen Empfänger, Insbesondere einem Fototransistor. Diese Bauteile degradieren jedoch über die Zeit insbesondere in Abhängigkeit vom verwendeten Eingangsstrom und der Umgebungstemperatur. Degradierte Optokoppler bewirken eine fehlerhafte Signalübertragung und damit Fehlfunktionen In der Motorelektronik, was wiederum andere Teile des EC-Motors negativ beeinflussen kann und die Lebensdauer des EC-Motors reduziert.

Das Gleichstrom-Übertragungsverhältnis (CTR) eines Optokopplers gibt das Verhältnis zwischen Eingangsstrom I_{F} und Ausgangsstrom I_{C} in Prozent an. Es ist bekannt, dass das CTR bei einer Degradation des Optokopplers abnimmt. Von Optokoppler-Herstellern gibt es hierzu allgemeine Lebensdauerdiagramme, die ein Alterungsverhältnis in Abhängigkeit von der Temperatur und dem Eingangsstrom angeben. Um das reale CTR eines Optokopplers in einem EC-Motor zu bestimmen, muss der Eingangsstrom I_{F} sowie der Ausgangsstrom I_{C} gemessen werden. Durch die galvanische Trennung der Messgrößen und die unterschiedlichen Massepotenziale ist die Auswertung nur mit größerem, kostspieligem Aufwand durch aufwändige Messschaltungen möglich.

Zudem wird das Lebensdauerende je nach Hersteller unterschiedlich definiert. Manche Hersteller gehen von einem Lebensdauerende aus, wenn sich das CTR um 50% vom Ausgangswert eines neuen Optokopplers verringert. Üblicherweise wird für das CTR ein sehr großer Toleranzbereich angegeben (Beispiel: Vishay TCLT1105 hat ein CTR von 50 % bis 150%). Das tatsächliche Lebensdauerende eines Optokopplers in einem EC-Motor kann mittels einer Beurteilung der Lebensdauerdiagramme der Hersteller und Messung bzw. Berechnung des CTR nicht zuverlässig ermittelt werden. Das tatsächliche Lebensdauerende ist sehr von der Beschaltung des Optokopplers, d.h. von der Motorelektronik, und dem realen Eingangsstrom und den realen Umgebungstemperaturen abhängig. Bei einem theoretisch definierten Lebensdauerende bei 50% des ursprünglichen CTR Ausgangswertes eines neuen Optokopplers kann die Funktionalität einer am Ausgang des Optokopplers geschalteten Motorelektronik praktisch immer noch gewährleistet sein.

Ein EC-Motor nach dem Stand der Technik ist aus der DE-A-20105050 bekannt.

Aufgabe der Erfindung ist es, einen EC-Motor zu schaffen, bei dem die Degradation eines Optokopplers zuverlässig bestimmt und die Lebensdauer des EC-Motors verbessert wird.

Bei einem EC-Motor der eingangs beschriebenen Art wird die Aufgabe erfindungsgemäß dadurch gelöst, dass eine Auswerteeinheit beim Schalten des Optokopplers eine Sättigungsspannung des Optokopplers am Ausgang des Optokopplers regelmäßig in Bezug auf eine Referenzschwelle auswertet und bei einem Überschreiten der Referenzschwelle durch die Sättigungsspannung ein Warnsignal erzeugt.

Ein solcher EC-Motor ermöglicht eine Bestimmung der realen akuten Degradation eines Optokopplers im EC-Motor und damit eine zuverlässigere Bestimmung der voraussichtlichen Lebensdauer des EC-Motors und warnt den Verwender des EC-Motors rechtzeitig vor Fehlfunktionen des EC-Motors aufgrund eines degradierten Optokopplers. Dies ermöglicht eine maximale Nutzung der Lebensdauer des Optokopplers für den verwendeten EC-Motor bei der bestimmten Verwendungsart und einen rechtzeitigen Austausch des degradierten Optokopplers vor einem wahrscheinlichen Ausfall. Somit werden Kosten optimiert und die Lebensdauer des EC-Motors verlängert.

Bei einer speziellen Ausführungsform der Erfindung umfasst die Auswerteeinheit zwei Widerstände und einen Komparator, wobei die Widerstände als Spannungsteiler derart ausgelegt sind, dass sie eine der Referenzschwelle entsprechende Referenzspannung am ersten Eingang des Komparators erzeugen und der Ausgang des Optokopplers an einem zweiten Eingang des Komparators angeschlossen ist, so dass beim Schalten des Optokopplers die Sättigungsspannung am zweiten Eingang des Komparators anliegt, und der Komparator bei einem Überschreiten der Referenzschwelle durch die Sättigungsspannung ein Warnsignal an einem Ausgang der Auswerteeinheit erzeugt. Dies ermöglicht eine besonders einfache und kostenoptimierte Ausführung der Auswerteeinheit.

Bei einer alternativen Ausführungsform der Erfindung umfasst die Auswerteeinheit einen Verstärker und einen Mikroprozessor, wobei der Eingang des Verstärkers am Ausgang des Optokopplers angeschlossen ist, so dass beim Schalten des Optokopplers die Sättigungsspannung am Eingang des Verstärkers anliegt, und der Ausgang des Verstärkers mit einem Eingang des Mikroprozessors verbunden ist, wobei der Mikroprozessor die verstärkte Sättigungsspannung auswertet und mit der Referenzschwelle vergleicht, und der Mikroprozessor bei einem Überschreiten der Referenzschwelle durch die verstärkte Sättigungsspannung ein Warnsignal an einem Ausgang der Auswerteeinheit erzeugt. Dies ermöglicht eine flexible Anpassung der Auswertelogik und Referenzschwelle in der Auswerteeinheit, so dass die Auswerteeinheit zum Beispiel an unterschiedliche Optokoppler-Typen durch einfache Programmierung der Auswerteeinheit angepasst werden kann.

In einer weiteren Ausführungsform der Erfindung erzeugt die Auswerteeinheit ein Stellsignal zur Regelung eines Eingangsstroms des Optokopplers in Abhängigkeit von dem Abstand des Betrags der Sättigungsspannung zu der Referenzschwelle, wobei das Stellsignal mit einem Eingang eines Stromreglers zur Regelung des Eingangsstroms direkt oder indirekt verbunden ist. Dies ermöglicht eine Optimierung des verwendeten Eingangsstroms für den Optokoppler in Bezug auf die aktuelle Verwendung und den aktuellen Zustand der Degradierung des Optokopplers, so dass die Lebensdauer des Optokopplers verlängert und gleichzeitig die verwendete Energie minimiert wird.

Besonders vorteilhaft ist es, wenn der erfindungsgemäße EC-Motor mindestens einen zweiten Optokoppler zur Übertragung eines zweiten Nutzsignals und einen Modulator und einen Demodulator umfasst, wobei der Modulator das Stellsignal für den Stromregler des ersten Optokopplers auf das über den zweiten Optokoppler zu übertragende Nutzsignal vor dem Eingang des zweiten Optokopplers aufmoduliert und der Demodulator nach dem Ausgang des zweiten Optokopplers das Stellsignal für den Stromregler des ersten Optokopplers von dem Nutzsignal demoduliert. Dies ermöglicht eine galvanische Trennung bei der Übertragung des Stellsignals und optimiert die Kosten, da ein bereits für die Übertragung eines Nutzsignals vorhandener Optokoppler zur Übertragung des Stellsignals verwendet wird. Somit wird ein zusätzlicher Optokoppler nur für die galvanisch getrennte Übertragung des Stellsignals eingespart.

Die vorgenannten sowie beanspruchten und in den Ausführungsbeispielen beschriebenen, erfindungsgemäß zu verwendenden Bauteile unterliegen in ihrer Größe, Form, Gestaltung, Materialauswahl und technischen Konzeptionen keinen besonderen Ausnahmebedingungen, so dass die in dem Anwendungsgebiet bekannten Auswahlkriterien uneingeschränkt Anwendung finden können.

Weitere Einzelheiten, Merkmale und vorteilhafte Weiterbildungen der Erfindung ergeben sich aus den im Folgenden beschriebenen und in den Zeichnungen dargestellten Ausführungsbeispielen sowie aus den Unteransprüchen. Es zeigen:
- Fig. 1: ein Blockschaltbild eines erfindungsgemäßen EC-Motors,
- Fig. 2: ein beispielhaftes bekanntes Lebensdauerdiagram eines Optokopplers,
- Fig. 3: Blockschaltbild zur Messung der Sättigungsspannung eines Optokopplers
- Fig. 4a: Verhalten der Sättigungsspannung In Abhängigkeit vom Eingangsstrom und der Betriebszeit während eines Langzeittests zur Bestimmung der Degradation eines Optokopplers,
- Fig. 4b: Verhalten der Sättigungsspannung in Abhängigkeit der Betriebszeit für einen bestimmten Eingangsstrom während eines Langzeittests zur Bestimmung der Degradation eines Optokopplers,
- Fig. 5: Blockschaltbild einer ersten Ausführungsform einer erfindungsgemäßen Ausgestaltung einer Auswerteeinheit der Sättigungsspannung,
- Fig. 6: Blockschaltbild einer zweiten Ausführungsform einer erfindungsgemäßen Ausgestaltung einer Auswerteeinheit der Sättigungsspannung,
- Fig. 7: Verhalten der Sättigungsspannung in Abhängigkeit vom Eingangsstrom und der Betriebszeit während eines Langzeittests zur Bestimmung der Degradation eines Optokopplers,
- Fig. 8: Schaltplan zur Regelung der Degradation eines Optokopplers bei einem erfindungsgemäßen EC-Motor,

In den verschiedenen Figuren der Zeichnung sind gleiche Teile stets mit denselben Bezugszeichen versehen.

Zu der anschließenden Beschreibung wird beansprucht, dass die Erfindung nicht auf die Ausführungsbeispiele und dabei nicht auf alle oder mehrere Merkmale von beschriebenen Merkmalskombinationen beschränkt ist, vielmehr Ist jedes einzelne Teilmerkmal des/jedes Ausführungsbeispiels auch losgelöst von allen anderen im Zusammenhang damit beschriebenen Teilmerkmalen für sich und auch in Kombination mit beliebigen Merkmalen eines anderen Ausführungsbeispiels von Bedeutung für den Gegenstand der Erfindung.

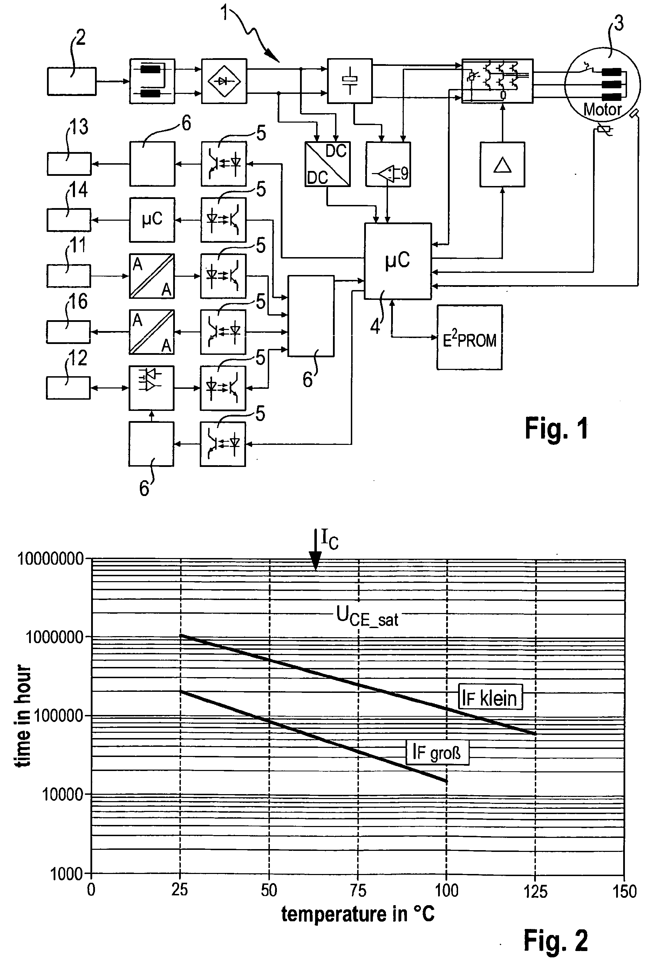

In Fig. 1 ist beispielhaft ein Blockschaltbild eines erfindungsgemäßen EC-Motors 1 dargestellt. Der EC-Motor 1 umfasst eine Spannungsversorgung 2, einen Motorantrieb 3 und eine Motorelektronik mit mehreren Signaleingängen, insbesondere ein analoger Pulsweitenmodulation-Eingang 11 und eine Eingangsleitung einer bi-direktionalen Schnittstelle 12, und mehrere Signalausgänge, insbesondere ein Tacho Ausgang 13, ein Eingang eines Busprozessors 14 zum Anschluss an einen Datenbus, eine Ausgangsleitung der bidirektionalen Schnittstelle 12 und ein analoger Pulsweitenmodulation-Ausgang 16. Außerdem weist die Motorelektronik beispielhaft einen Mikroprozessor 4 zur Signalverarbeitung und Steuerung des EC-Motors 1 auf. Zur galvanischen Trennung der Motorelektronik, insbesondere des Mikroprozessors 4, von den Signaleingängen und Signalausgängen ist zwischen ihnen und der Motorelektronik, insbesondere dem Mikroprozessor 4, Jeweils ein Optokoppler 5 geschaltet. Dabei ist der Ausgang des Optokopplers 5 mit einer Auswerteeinheit 6 verbunden. Die Auswerteeinheit 6 misst den Ausgang des Optokopplers 5 und erzeugt ein Warnsignal, das den Status der Degradation des jeweiligen Optokopplers 5 darstellt.

In Fig. 2 ist ein bekanntes beispielhaftes Lebensdauerdiagramm eines Herstellers von Optokopplern 5 für einen bestimmten Optokoppler 5 dargestellt. Es ist bekannt, dass das CTR bei einer Degradation des Optokopplers 5 abnimmt, d.h. dass bei dem gleichen Eingangsstrom der Ausgangsstrom abnimmt. Aus Fig. 2 ergibt sich, dass sich die Lebensdauer des Optokopplers 5 bei einer Verwendung von kleineren Eingangsströmen I_{F} und bei niedrigeren Umgebungstemperaturen verlängert.

Die Erfindung beruht auf der Erkenntnis, dass es für die Bestimmung einer realen Lebensdauer eines Optokopplers 5 im EC-Motor 1 ausschlaggebend ist, das die verwendeten Signalpegel am Ausgang des Optokopplers 5 von der Motorelektronik noch zuverlässig erkannt und voneinander unterschieden werden können. Es wurde überraschenderweise erkannt, dass die Sättigungsspannung U_{CE} mit steigender Degradation des Optokopplers 5 ansteigt. Ab einem gewissen Zeitpunkt ist die Sättigungsspannung U_{CE_Sat} so hoch, dass ein geschalteter und ein nicht geschalteter Zustand des Optokopplers 5 von der Motorelektronik nicht zuverlässig unterschieden werden kann, wodurch es zu unerwünschten Fehlfunktionen der Motorelektronik kommt. Applikationsabhängig, d.h. insbesondere abhängig von der Motorelektronik, gibt es eine maximal zulässige Sättigungsspannung U_{REF} als Referenzschwelle, bei der Schaltungsteile, die dem Optokoppler 5 nachgeschaltet sind, gerade noch einwandfrei funktionieren. Bei typischen Motorelektroniken hat sich herausgestellt, dass der Wert für U_{REF} in Abhängigkeit von der Empfindlichkeit der Motorelektronik zwischen 0,3 V und 1 V liegt. Bei einer Überschreitung der Referenzschwelle U_{REF} kann z.B. von der Auswerteeinheit 6 eine Warnmeldung ausgegeben werden.

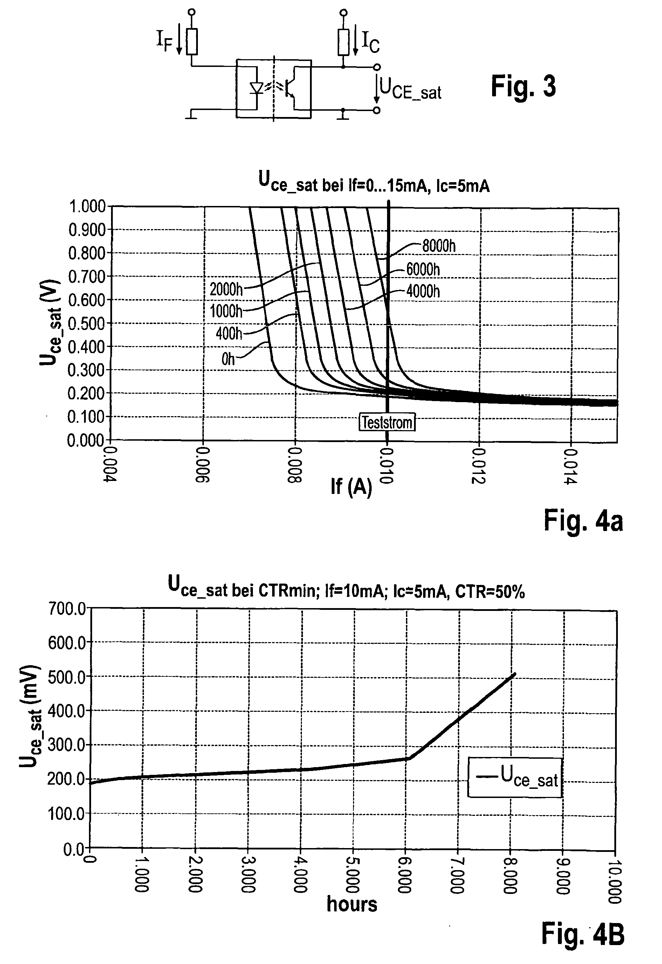

Zur Bestätigung der Abhängigkeit der Sättigungsspannung U_{CE_Sat} von der Degradation eines Optokopplers 5 wurde ein Langzeittest gemäß Fig. 3 mit einem Optokoppler 31 durchgeführt. Der dazu verwendete Optokoppler 5, insbesondere ein Vishay TCLT1105, gewährleistet laut Datenblatt mindestens ein CTR von 50% bis zum Lebensdauerende. Die Sättigungsspannung U_{CE_Sat} des Optokopplers 31 kann mit einfachem Aufwand am Ausgang des Optokopplers 5 gemäß der Schaltung in Fig. 3 gemessen werden. Um den Alterungseffekt des Optokopplers 5 zu beschleunigen, wurde der Optokoppler 5 bei einer Umgebungstemperatur T_{A} = 60°C mit einem Eingangsstrom von I_{F}=60 mA statisch bestromt. In regelmäßigen zeitlichen Abständen (bei 0, 400, 1000, 2000, 4000, 6000 und 8000 Stunden Betriebszeit) wurde die Sättigungsspannung U_{CE_Sat} am Ausgang des Optokopplers 5 in Abhängigkeit vom Eingangsstrom I_{F} gemessen, wobei der Eingangsstrom I_{F} während der Messung von 0 bis 15 mA kontinuierlich erhöht wurde. Für die Messung der Sättigungsspannung U_{CE_Sat} wurde ausgangsseitig der Arbeitspunkt des Optokopplers 5 mit einem Ausgangsstrom I_{C} von 5 mA eingestellt.

Die Messergebnisse des Langzeittests sind in Fig. 4a und Fig. 4b dargestellt. Fig. 4a zeigt das Ausgangsverhalten des Optokopplers 5 in Bezug auf die Sättigungsspannung U_{CE_Sat} über eine Betriebsdauer von bis zu 8000 Stunden (h) in Abhängigkeit vom Eingangsstrom I_{F}. Die Messung wurde mittels eines Curve Tracers (KEITHLEY 2410) durchgeführt. Fig. 4b zeigt den Verlauf der Sättigungsspannung U_{CE_Sat} über die Betriebszeit am eingestellten Arbeitspunkt bei einem Eingangsstrom I_{F} = 10 mA und einem Ausgangsstrom I_{C} = 5 mA. Dies entspricht bei dem gewählten Optokoppler 5 dem Wert, bei welchem der Bauteilhersteller die Sättigungsspannung U_{CE_Sat} im Datenblatt bei minimalen Übertragungsfaktor CTR spezifiziert. Bei einem CTR von mindestens 50% muss der Optokoppler 5 noch sicher 5 mA treiben, und die Sättigungsspannung U_{CE_Sat} sollte bei einem funktionsfähigen Optokoppler 5 im niedrigen Spannungsbereich liegen. Die Messungen zeigen eine deutliche Degradation über die Betriebszeit. Im Ausgangszustand (0 h) lag die Sättigungsspannung U_{CE_Sat} bei circa 187mV. Ab circa 6000h wird der Kennlinienknickbereich überschritten, so dass die Sättigungsspannung U_{CE_Sat} sehr stark zunimmt. Bei 8000h steigt die Sättigungsspannung U_{CE_Sat} bereits auf 512mV.

Somit kann bei einem EC-Motor 1 mittels einer relativ einfachen Messung der Sättigungsspannung U_{CE_Sat} am Ausgang des Optokopplers 5 durch eine Auswerteeinheit 6 die reale Degradation des Optokopplers 5 in Bezug auf die verwendete Motorelektronik des EC-Motors 1 bestimmt werden. Eine derartige Bestimmung der Degradation durch Messung der Sättigungsspannung U_{CE_Sat} hat den weiteren Vorteil, dass sie unabhängig von Eingangsstrom und Umgebungstemperatur arbeitet. Sie lässt sich bei jedem Arbeitspunkt in der Praxis anwenden. Die Messung wird während eines Einschaltens der LED des Optokopplers 5, d.h. während eines niedrigen Signalpegels am Ausgang des Optokopplers, durchgeführt. Die Referenzschwelle U_{REF} gibt an, bis zu welcher maximalen Sättigungsspannung U_{CE_Sat} die Motorelektronik noch einen niedrigen von einem hohen Signalpegel am Ausgang des Optokopplers 5 unterscheiden kann, so dass eine Funktionsfähigkeit der Motorelektronik sichergestellt ist. Beim Überschreiten der Referenzschwelle U_{REF} erzeugt die Auswerteeinheit 6 z.B. eine Warnmeldung für den Anwender, bevor die Funktion der Motorelektronik nicht mehr gegeben ist. Somit besteht für den Anwender ausreichend Zeit, um für einen Austausch des Optokopplers 5 ohne längeren Gerätestillstand zu sorgen.

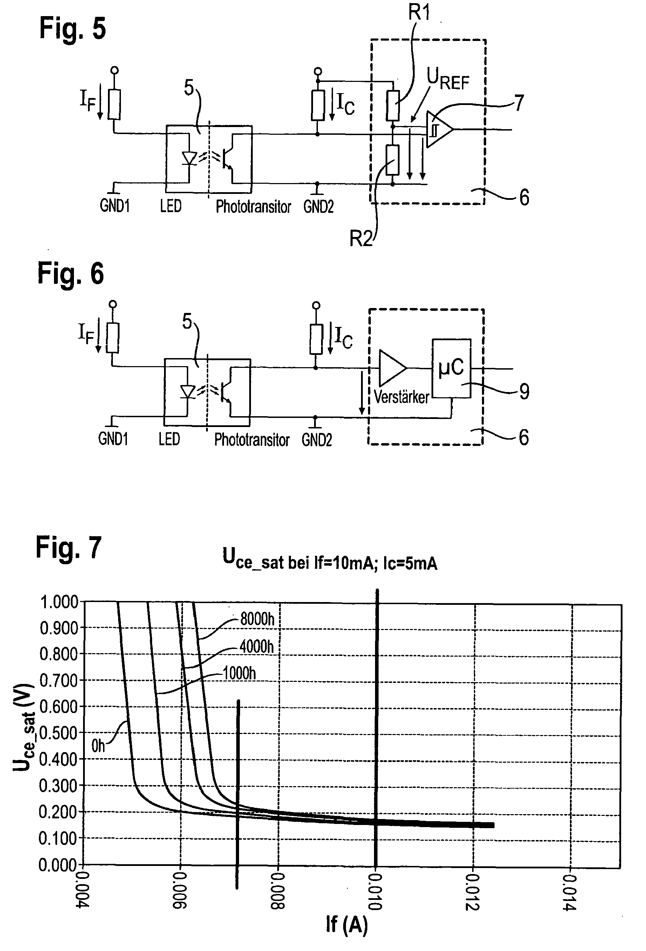

In Fig. 5 ist eine spezielle Ausführungsform der Auswerteeinheit 6 dargestellt. Die Auswerteeinheit 6 umfasst zwei in Reihe geschaltete Widerstände R1, R2 und einen Komparator 7. Die Auswerteeinheit ist über den Widerstand R1 mit der Spannungsquelle der Motorelektronik verbunden. Der Komparator 7 besitzt zwei Spannungseingänge, wobei ein erster Spannungseingang zwischen den beiden Widerständen R1 und R2 geschaltet ist. Die Widerstände R1 und R2 bilden einen Spannungsteiler und sind derart in ihrem elektrischen Widerstand ausgelegt, dass sie an dem ersten Spannungseingang des Komparators 7 eine Referenzspannung bilden, die der Referenzschwelle U_{REF} entspricht. Der zweite Spannungseingang des Komparators 7 ist an den Ausgang des Optokopplers 5 angeschlossen, so dass an dem zweiten Spannungseingang des Komparators beim geschalteten Optokoppler die Sättigungsspannung U_{CE_Sat} anliegt. Die Auswerteeinheit 6 misst somit die Sättigungsspannung U_{CE_Sat} und vergleicht sie mittels des Komparators 7 mit der Referenzspannung. Falls die Sättigungsspännung U_{CE_Sat} die Referenzspannung übersteigt, gibt der Komparator 7 der Auswerteeinheit 6 ein Warnsignal aus, das über einen nötigen Austausch des Optokopplers 5 informiert.

In Fig. 6 ist eine alternative Ausführungsform der Auswerteeinheit 6 dargestellt. Die Auswerteeinheit 6 umfasst einen Verstärker 8 und einen Mikroprozessor 9. Ein Eingang des Verstärkers 8 ist an den Ausgang des Optokopplers 5 angeschlossen, so dass die Sättigungsspannung U_{CE_Sat} am Eingang des Verstärkers 8 anliegt, wenn der Optokoppler 5 geschaltet ist. Der Mikroprozessor 9 ist an den Ausgang des Verstärkers 8 angeschlossen und wertet die verstärkte Sättigungsspannung U_{CE_Sat} aus, indem er die verstärkte Sättigungsspannung U_{CE_Sat} mit einer an die Verstärkung angepassten Referenzschwelle U_{REF} vergleicht und bei einem Überschreiten der Referenzschwelle U_{REF} ein Warnsignal an einem Ausgang erzeugt.

Die Auswerteeinheit 6 kann auch teilweise in der Motorelektronik integriert sein und zum Beispiel den Mikroprozessor 4 der Motorelektronik anstatt eines separaten Mikroprozessors 9 nutzen.

Eine weitere Ausführungsform der Erfindung basiert auf der Erkenntnis aus den Messergebnissen des Langzeittests, dass für den benötigten Ausgangsstrom I_{C} nicht immer der ganze Sendestrom I_{F} an der LED notwendig ist. Der theoretisch benötigte Eingangsstrom I_{F}, um Sättigung zu erreichen, ergibt sich aus dem eingestellten Ausgangsstrom I_{C} am Ausgang des Optokopplers 5 und dem CTR des Optokopplers 5 (I_{F} = I_{C} * 100/ CTR). Insbesondere bei einem neuen Optokoppler 5, der noch weit von seinem Lebensdauerende entfernt sind, ist zur Erreichung einer für die Motorelektronik ausreichend niedrigen Sättigungsspannung U_{CE_Sat} < U_{REF} in Wirklichkeit ein geringerer Eingangsstrom I_{F} ausreichend. Durch eine Rückkopplung auf den Eingang des Optokopplers 5 kann der Eingangsstrom I_{F} so weit reduziert werden, bis die erfasste Sättigungsspannung U_{CE_Sat} gerade noch unterhalb der Referenzschwelle U_{REF} liegt.

Ist für die Motorelektronik zum Beispiel eine Referenzschwelle von U_{REF} = 0,3 V bestimmt, so ergibt sich für den Optokoppler 5 aus Fig. 7, bei dem nach 8000h der Alterungseffekt noch nicht so deutlich ist als nach Fig. 4a, dass bis zu einer Betriebszeit von 8000 h für einen Ausgangsstrom von I_{C} = 5 mA mit einem CTR des Optokopplers von 50% bereits ein Eingangsstrom I_{F} von etwa 7 mA ausreichend ist, um eine ausreichend niedrige Sättigungsspannung < 0,3 V zu erreichen. Der mittels des CTR berechnete Eingangsstrom I_{F} wäre 10 mA. Da die Degradation des Optokopplers 5 insbesondere stark von der Höhe des Eingangsstroms I_{F} abhängt (siehe auch Fig. 2), wird durch eine Reduzierung des Eingangsstromes I_{F} die Lebensdauer relativ zu einem Betrieb des Optokopplers 5 mit einem höheren Eingangsstrom I_{F} verlängert. Zusätzlich wird durch diese Ausführungsform der Erfindung auch Energie beim Betrieb des Optokopplers eingespart.

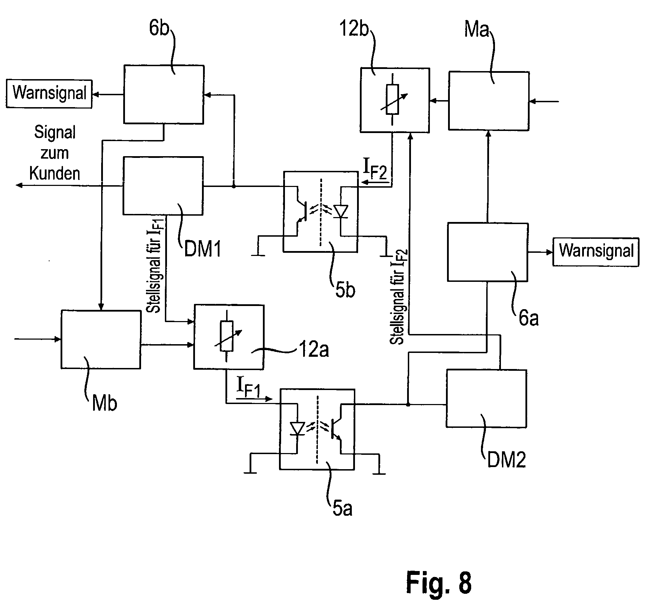

Fig. 8 zeigt ein beispielhaftes Blockschaltbild einer Ausführungsform eines EC-Motors 1 mit einer erfindungsgemäßen Rückkopplung des Optokopplers 5. Bei dieser Ausführungsform des EC-Motors ist eine bi-direktionale Signalübertragung möglich, d.h. es werden Signale von den Signaleingängen über einen ersten Optokoppler 5a zur Motorsteuerung und von der Motorsteuerung über einen zweiten Optokoppler 5b zu den Signalausgängen des EC-Motors übertragen. Eine erste Auswerteeinheit 6a erfasst am Ausgang des Optokopplers 5a die aktuelle Sättigungsspannung U_{CE_Sat_5a} und vergleicht sie mit einer Referenzschwelle U_{REF}. Liegt die Sättigungsspannung U_{CE_Sat_5a} über der Referenzschwelle U_{REF}, so ist das Lebensdauerende des ersten Optokopplers 5a erreicht, und es wird wie bereits oben beschrieben ein Warnsignal erzeugt. Liegt die Sättigungsspannung U_{CE_Sat_5a} unterhalb der Referenzschwelle U_{REF}, erfolgt in Abhängigkeit von der Sättigungsspannung U_{CE_Sat}_₅ₐ eine Berechnung eines Stellsignals S_{F1} mittels eines Mikroprozessors, das für eine Stromreglung des Eingangsstromes I_{F1} des ersten Optokopplers 5a mittels eines am Eingang des Optokopplers 5a angeschlossenen Stromreglers 12a verwendet wird. Der Eingangsstrom I_{F1} wird so weit reduziert, bis die erfasste Sättigungsspannung U_{CE_Sat_5a} noch unterhalb der Referenzschwelle U_{REF} liegt. Mit fortschreitender Degradation steigt für einen bestimmten Eingangsstrom I_{F1} die Sättigungsspannung U_{CE_Sat} an, so dass der Eingangsstrom I_{F1} mit fortschreitender Lebensdauer erhöht wird, jedoch immer nur so viel, dass die Sättigungsspannung U_{CE}__{Sat_5a} unterhalb der Referenzschwelle U_{REF} bleibt. Ab einer gewissen Betriebszeit wird eine Erhöhung des Eingangsstromes I_{F1} die Sättigungsspannung U_{CE_Sat} nicht mehr unter der Referenzschwelle U_{REF} halten, so dass in diesem Fall das Warnsignal wie oben beschrieben von der ersten Auswerteeinheit 6a erzeugt wird. Dabei ist die Referenzschwelle U_{REF} an die bestimmte Anwendung derart angepasst, dass sie jeweils noch ausreichend unter dem wirklichen Lebensdauerende liegt.

Zur Übertragung des Stellsignals S_{F1} zurück zum galvanisch getrennten Eingang des Optokopplers 5a wird der Rückkanal für die Übertragung eines Nutzsignals als Ausgangssignal von der Motorsteuerung über den zweiten Optokoppler 5b zu den Signalausgängen des EC-Motors 1 verwendet. Allerdings können mit den Optokopplern 5a und 5b nur digitale Signale übertragen werden. Daher wird das analoge Stellsignal S_{F1} für die Stromregelung des ersten Optokopplers 5a auf das Nutzsignal der Motorsteuerung am Eingang des zweiten Optokopplers 5b mittels eines Modulators 13a moduliert und am Ausgang des zweiten Optokopplers 5b mittels eines Demodulators 14a demoduliert und zu dem Stromregler 12a geführt. Die Reduzierung des Sendestroms I_{F1} begünstigt die Lebensdauer des ersten Optokopplers 5a und reduziert die notwendige Energie in der Schaltung.

Dieses Prinzip lässt sich auch auf den zweiten Optokoppler 5b übertragen. Entsprechend erfasst eine zweite Auswerteeinheit 6b am Ausgang des zweiten Optokopplers 5b die aktuelle Sättigungsspannung U_{CE_Sat_5b} und vergleicht sie mit einer Referenzschwelle U_{REF}. Liegt die Sättigungsspannung U_{CE_Sat_5b} über der Referenzschwelle U_{REF}, so ist das Lebensdauerende des zweiten Optokopplers 5b erreicht, und es wird wie bereits oben beschrieben ein Warnsignal erzeugt. Liegt die Sättigungsspannung U_{CE_Sat_5b} unterhalb der Referenzschwelle U_{REF}, erfolgt in Abhängigkeit von der Sättigungsspannung U_{CE_Sat_5b} eine Berechnung eines Stellsignals S_{F2} mittels eines Mikroprozessors, das für eine Stromreglung des Eingangsstromes I_{F2} mittels eines am Eingang des zweiten Optokopplers 5b angeschlossenen zweiten Stromreglers 12b verwendet wird. Der Eingangsstrom I_{F2} wird entsprechend geregelt. Dazu wird ein zweites analoges Stellsignal S_{F2} für die Stromregelung des zweiten Optokopplers 5b auf das Nutzsignal am Eingang des ersten Optokopplers 5a mittels eines zweiten Modulators 13b moduliert und am Ausgang des ersten Optokopplers 5a mittels eines zweiten Demodulators 14b demoduliert und zu dem zweiten Stromregler 12b geführt.

Die Erfindung ist nicht auf die dargestellten und beschriebenen Ausführungsbeispiele beschränkt, sondern umfasst auch alle im Sinne der Erfindung gleichwirkenden Ausführungen. Es wird ausdrücklich betont, dass die Ausführungsbeispiele nicht auf alle Merkmale in Kombination beschränkt sind, vielmehr kann jedes einzelne Teilmerkmal auch losgelöst von allen anderen Teilmerkmalen für sich eine erfinderische Bedeutung haben. Ferner ist die Erfindung bislang auch noch nicht auf die im Anspruch 1 definierte Merkmalskombination beschränkt, sondern kann auch durch jede beliebige andere Kombination von bestimmten Merkmalen aller insgesamt offenbarten Einzelmerkmalen definiert sein. Dies bedeutet, dass grundsätzlich praktisch jedes Einzelmerkmal des Anspruchs 1 weggelassen bzw. durch mindestens ein an anderer Stelle der Anmeldung offenbartes Einzelmerkmal ersetzt werden kann.

## Patentansprüche

1. EC-Motor (1) umfassend eine Motorelektronik, einen Signaleingang oder einen Signalausgang und einen Optokoppler (5, 5a, 5b) zur galvanisch getrennten Übertragung eines Nutzsignals zwischen der Motorsteuerung und dem Signaleingang oder dem Signalausgang,
**dadurch gekennzeichnet, dass** eine Auswerteeinheit (6, 6a, 6b) beim Schalten des Optokopplers (5, 5a, 5b) eine Sättigungsspannung (U_{CE_Sat}) des Optokopplers (5, 5a, 5b) am Ausgang des Optokopplers (5, 5a, 5b) regelmäßig in Bezug auf eine Referenzschwelle (U_{REF}) auswertet und bei einem Überschreiten der Referenzschwelle (U_{REF}) durch die Sättigungsspannung (U_{CE_Sat}) ein Warnsignal erzeugt.

2. EC-Motor nach Anspruch 1,
**dadurch gekennzeichnet, dass** die Auswerteeinheit (6, 6a, 6b) zwei Widerstände (R1, R2) und einen Komparator (7) umfasst, wobei die Widerstände als Spannungsteiler derart ausgelegt sind, dass sie eine der Referenzschwelle (U_{REF}) entsprechende Referenzspannung am ersten Eingang des Komparators (7) erzeugen und der Ausgang des Optokopplers (5, 5a, 5b) an einem zweiten Eingang des Komparators (7) angeschlossen ist, so dass beim Schalten des Optokopplers (5, 5a, 5b) die Sättigungsspannung (U_{CE_Sat}) am zweiten Eingang des Komparators (7) anliegt, und der Komparator (7) bei einem Überschreiten der Referenzschwelle (U_{REF}) durch die Sättigungsspannung (U_{CE_Sat}) ein Warnsignal an einem Ausgang der Auswerteeinheit (6a, 6b, 6c) erzeugt.

3. EC-Motor nach Anspruch 1,
**dadurch gekennzeichnet, dass** die Auswerteeinheit (6, 6a, 6b) einen Verstärker (8) und einen Mikroprozessor (9) umfasst, wobei der Eingang des Verstärkers (8) am Ausgang des Optokopplers (5, 5a, 5b) angeschlossen ist, so dass beim Schalten des Optokopplers (5, 5a, 5b) die Sättigungsspannung (U_{CE_Sat}) am Eingang des Verstärkers (8) anliegt, und der Ausgang des Verstärkers (8) mit einem Eingang des Mikroprozessors (9) verbunden ist, wobei der Mikroprozessor (9) die verstärkte Sättigungsspannung (U_{CE_Sat}) auswertet, und mit der Referenzschwelle (U_{REF}) vergleicht und der Mikroprozessor (9) bei einem Überschreiten der Referenzschwelle (U_{REF}) durch die verstärkte Sättigungsspannung (U_{CE_Sat}) ein Warnsignal an einem Ausgang der Auswerteeinheit (6a, 6b, 6c) erzeugt.

4. EC-Motor nach einem der Ansprüche 1 bis 3,
**dadurch gekennzeichnet, dass** die Auswerteeinheit (6, 6a, 6b) ein Stellsignal (S_{F1}, S_{F2}) zur Regelung eines Eingangsstroms (I_{F1}, I_{F2}) des Optokopplers (5, 5a, 5b) in Abhängigkeit von dem Abstand des Betrags der Sättigungsspannung (U_{CE_Sat}) zu der Referenzschwelle (U_{REF}) erzeugt, wobei das Stellsignal (S_{F1}, S_{F2}) mit einem Eingang eines Stromreglers (12a, 12b) zur Regelung des Eingangsstroms (I_{F1}, I_{F2}) direkt oder indirekt verbunden ist.

5. EC-Motor nach Anspruch 4,
**dadurch gekennzeichnet, dass** der EC-Motor mindestens einen zweiten Optokoppler zur Übertragung eines zweiten Nutzsignals und einen Modulator (13a, 13b) und einen Demodulator (14a, 14b) umfasst, wobei der Modulator (13a, 13b) das Stellsignal (S_{F1}, S_{F2}) für den Stromregler (12a, 12b) des ersten Optokopplers (5a, 5b) auf das über den zweiten Optokoppler (5, 5a, 5b) zu übertragende Nutzsignal vor dem Eingang des zweiten Optokopplers (5, 5a, 5b) aufmoduliert und der Demodulator nach dem Ausgang des zweiten Optokopplers (5, 5a, 5b) das Stellsignal (S_{F1}, S_{F2}) für den Stromregler (12a, 12b) des ersten Optokopplers (5, 5a, 5b) von dem Nutzsignal demoduliert.

6. EC-Motor nach Anspruch 5,
**dadurch gekennzeichnet, dass** der EC-Motor mindestens eine zweite Auswerteeinheit (6, 6a, 6b) umfasst, wobei die zweite Auswerteeinheit (6, 6a, 6b) ein zweites Stellsignal (S_{F1}, S_{F2}) zur Regelung eines Eingangsstroms (I_{F1}, I_{F2}) des zweiten Optokopplers (5, 5a, 5b) in Abhängigkeit von dem Abstand des Betrags der Sättigungsspannung (U_{CE_Sat}) des zweiten Optokopplers (5, 5a, 5b) zu der Referenzschwelle (U_{REF}) erzeugt, wobei das zweite Stellsignal (S_{F1}, S_{F2}) mit einem Eingang eines zweiten Stromreglers (12a, 12b) zur Regelung des Eingangsstroms (I_{F1, IF2}) des zweiten Optokopplers (5, 5a, 5b) direkt oder indirekt verbunden ist.

7. EC-Motor nach Anspruch 6,
**dadurch gekennzeichnet, dass** der EC-Motor einen zweiten Modulator (13a, 13b) und einen zweiten Demodulator (14a, 14b) umfasst, wobei der zweite Modulator (13a, 13b) das Stellsignal (S_{F1}, S_{F2}) für den Stromregler (12a, 12b) des zweiten Optokopplers (5a, 5b) auf das über den ersten Optokoppler (5a, 5b) zu übertragende Nutzsignal vor dem Eingang des ersten Optokopplers (5a, 5b) aufmoduliert und der Demodulator nach dem Ausgang des ersten Optokopplers (5a, 5b) das Stellsignal (S_{F1}, S_{F2}) für den Stromregler (12a, 12b) des zweiten Optokopplers (5a, 5b) von dem Nutzsignal demoduliert.

## Claims

1. EC motor (1) comprising a motor electronics, a signal input or a signal output, and an optocoupler (5, 5a, 5b) for the galvanically isolated transmission of a useful signal between the motor control unit and the signal input or the signal output, **characterised in that**, when the optocoupler (5, 5a, 5b) is wired, an evaluation unit (6, 6a, 6b) regularly evaluates a saturation voltage (U_{CE_Sat}) of the optocoupler (5, 5a, 5b) at the output of said optocoupler (5, 5a, 5b) in relation to a reference threshold (U_{REF}) and generates a warning signal when the saturation voltage (U_{CE_Sat}) exceeds the reference threshold (U_{REF})

2. EC motor according to claim 1, **characterised in that** the evaluation unit (6, 6a, 6b) comprises two resistors (R1, R2) and a comparator (7), the resistors being designed as voltage distributors such that they generate a reference voltage, corresponding to the reference threshold (U_{REF}), at the first input of the comparator (7), and the output of the optocoupler (5, 5a, 5b) is connected to a second input of the comparator (7), so that the saturation voltage (U_{CE_Sat}) is applied at the second input of the comparator (7) when the optocoupler (5, 5a, 5b) is wired, and the comparator (7) generates a warning signal at an output of the evaluation unit (6a, 6b, 6c) when the saturation voltage (U_{CE_Sat}) exceeds the reference threshold (U_{REF}).

3. EC motor according to claim 1, **characterised in that** the evaluation unit (6, 6a, 6b) comprises an amplifier (8) and a microprocessor (9), the input of the amplifier (8) being connected to the output of the optocoupler (5, 5a, 5b), so that the saturation voltage (U_{CE_Sat}) is applied at the input of the amplifier (8) when the optocoupler (5, 5a, 5b) is wired, and the output of the amplifier (8) is connected to an input of the microprocessor (9), the microprocessor (9) evaluating the amplified saturation voltage (U_{CE_Sat}) and comparing this with the reference threshold (U_{REF}), and the microprocessor (9) generating a warning signal at an output of the evaluation unit (6, 6a, 6b) when the amplified saturation voltage (U_{CE_Sat}) exceeds the reference threshold (U_{REF}).

4. EC motor according to any of claims 1 to 3, **characterised in that** the evaluation unit (6, 6a, 6b) generates an adjustment signal (S_{F1}, S_{F2}) for the closed-loop control of an input current (I_{F1}, I_{F2}) of the optocoupler (5, 5a, 5b) on the basis of the ratio of the value of the saturation voltage (U_{CE_Sat}) to the reference threshold (U_{REF}), the adjustment signal (S_{F1}, S_{F2}) being directly or indirectly connected to an input of a current regulator (12a, 12b) for the closed-loop control of the input current (I_{F1}, I_{F2}).

5. EC motor according to claim 4, **characterised in that** the EC motor comprises at least one second optocoupler for transmitting a second useful signal and a modulator (13a, 13b) and a demodulator (14a, 14b), the modulator (13a, 13b) modulating, upstream of the input of the second optocoupler (5, 5a, 5b), the adjustment signal (S_{F1}, S_{F2}) for the current regulator (12a, 12b) of the first optocoupler (5a, 5b) onto the useful signal to be transmitted via the second optocoupler (5, 5a, 5b), and the demodulator demodulating, downstream of the output of the second optocoupler (5, 5a, 5b), the adjustment signal (S_{F1}, S_{F2}) for the current regulator (12a, 12b) of the first optocoupler (5, 5a, 5b) from the useful signal.

6. EC motor according to claim 5, **characterised in that** the EC motor comprises at least one second evaluation unit (6, 6a, 6b), the second evaluation unit (6, 6a, 6b) generating a second adjustment signal (S_{F1}, S_{F2}) for the closed-loop control of an input current (I_{F1}, I_{F2}) of the second optocoupler (5, 5a, 5b) according to the ratio of the value of the saturation voltage(U_{CE_Sat}) of the second optocoupler (5, 5a, 5b) to the reference threshold (U_{REF}), the second adjustment signal (S_{F1}, S_{F2}) being either directly or indirectly connected to an input of a second current regulator (12a, 12b) for the closed-loop control of the input current (I_{F1}, I_{F2}) of the second optocoupler (5, 5a, 5b).

7. EC motor according to claim 6, **characterised in that** the EC motor comprises a second modulator (13a, 13b) and a second demodulator (14a, 14b), the second modulator (13a, 13b) modulating, upstream of the input of the first optocoupler (5a, 5b), the adjustment signal (S_{F1}, S_{F2}) for the current regulator (12a, 12b) of the second optocoupler (5a, 5b) onto the useful signal to be transmitted via the first optocoupler (5a, 5b), and the demodulator demodulating, downstream of the output of the first optocoupler (5a, 5b), the adjustment signal (S_{F1}, S_{F2}) for the current regulator (12a, 12b) of the second optocoupler (5a, 5b) from the useful signal.

## Revendications

1. Moteur EC (1) comprenant une électronique de moteur, une entrée de signal ou une sortie de signal, et un photocoupleur (5, 5a, 5b) pour la transmission galvaniquement isolé d'un signal utile entre l'unité de commande de moteur et l'entrée de signal ou la sortie de signal, **caractérisé en ce qu'** une unité d'évaluation (6, 6a, 6b) de photcoupleur (5, 5a, 5b) évalue périodiquement une tension de saturation (U_{CE_Sat}) du photocoupleur (5, 5a, 5b) à la ledit sortie du photocoupleur (5, 5a, 5b) par rapport à un seuil de référence (U_{REF}) et génère un signal d'alarme lorsque la tension de saturation (U_{CE_Sat}) dépasse le seuil de référence (U_{REF}).

2. Moteur EC selon la revendication 1, **caractérisé en ce que** l'unité d'évaluation (6, 6a, 6b) comprend deux résistances (R1, R2) et un comparateur (7), les résistances étant réalisés sous forme de distributeurs de tension de telle sorte qu'ils génèrent une tension de référence, correspondant au seuil de référence (U_{REF}) à la première entrée du comparateur (7), et la sortie du photocoupleur (5, 5a, 5b) est reliée à une deuxième entrée du comparateur (7), de telle sorte que la tension de saturation (U_{CE_Sat}) est appliqué à la seconde entrée du comparateur (7) lorsque le photocopieur (5, 5a, 5b) est connecte, et le comparateur (7) génère un signal d'alarme à une sortie de l'unité d'évaluation (6a, 6b, 6c) lorsque la tension de saturation (U_{CE_Sat}) dépasse le seuil de référence (U_{REF}).

3. Moteur EC selon la revendication 1, **caractérisé en ce que** l'unité d'évaluation (6, 6a, 6b) comprend un amplificateur (8) et un microprocesseur (9), l'entrée de l'amplificateur (8) étant reliée à la sortie du photocoupleur (5, 5a, 5b), de sorte que la tension de saturation (U_{CE_Sat}) est appliqué à l'entrée de l'amplificateur (8) lorsque le photocoupleur (5, 5a, 5b) est câblé, et la sortie de l'amplificateur (8) est reliée à une entrée du microprocesseur (9), le microprocesseur (9) évalue la tension de saturation amplifié (U_{CE_Sat}) et assimile celle-ci avec le seuil de référence (U_{REF}), et le microprocesseur (9) générant un signal d'alarme à une sortie l'unité d'évaluation (6, 6a, 6b) lorsque la tension de saturation amplifié (U_{CE}__{Sat}) dépasse le seuil de référence (U_{REF}).

4. Moteur EC selon l'une quelconque des revendications 1 à 3, **caractérisé en ce que** l'unité d'évaluation (6, 6a, 6b) générant un signal de réglage (S_{F1}, S_{F2}) pour la commande d'un courant d'entrée (I_{F1}, I_{F2}) du photocoupleur (5, 5a, 5b) sur la base du rapport de la valeur de la tension de saturation (U_{CE_Sat}) au seuil de référence (U_{REF}), le signal de réglage (S_{F1}, S_{F2}) étant reliée directement ou indirectement à une entrée d'un régulateur de courant (12a, 12b) pour la commande du courant d'entrée (I_{F1}, I_{F2}).

5. Moteur EC selon la revendication 4, **caractérisé en ce que** le moteur EC comprend au moins un deuxième photocoupleur pour transmettre un deuxième signal utile et un modulateur (13a, 13b) et un démodulateur (14a, 14b), dans lequel le modulateur (13a, 13b) module, en amont de l'entrée du deuxième photocoupleur (5, 5a, 5b) le signal de réglage (S_{F1}, S_{F2}) pour le régulateur de courant (12a, 12b) du premier photocoupleur (5a, 5b) sur le signal utile à transmettre par l'intermédiaire du second photocoupleur (5, 5a, 5b), et le démodulateu démoduler, en aval de la sortie du second photocoupleur (5, 5a, 5b) le signal de réglage (S_{F1}, S_{F2}) pour le régulateur de courant (12a, 12b) du premier coupleur optique (5, 5a, 5b) à partir du signal utile.

6. Moteur EC selon la revendication 5, **caractérisé en ce que** le moteur EC comprend au moins une deuxième unité d'évaluation (6, 6a, 6b), la seconde unité d'évaluation (6, 6a, 6b) générant un deuxième signal de réglage (S_{F1}, S_{F2}) pour la commande d'un courant d'entrée (I_{F1}, I_{F2}) du deuxième photocoupleur (5, 5a, 5b) en fonction du rapport de la valeur de la tension de saturation (U_{CE_Sat}) du second coupleur optique (5, 5a, 5b) au seuil de référence (U_{REF}), dans lequel le deuxième signal de réglage (S_{F1}, S_{F2}) étant reliée directement ou indirectement à une entrée d'un second régulateur de courant (12a, 12b) pour la commande du courant d'entrée (I_{F1}, I_{F2}) de la deuxième photocoupleur (5, 5a, 5b).

7. Moteur EC selon la revendication 6, **caractérisé en ce que** le moteur EC comprend un second modulateur (13a, 13b) et un second démodulateur (14a, 14b), le second modulateur (13a, 3b) module en amont de centrée de la premier photocoupleur (5a, 5b) le signal de réglage (S_{F1}, S_{F2}) pour le régulateur de courant (12a, 12b) du second photocoupleur (5a, 5b) sur le signal utile à transmettre par l'intermédiaire du premier photocoupleur (5a, 5b) et le démodulateur démodule en aval de la sortie du premier photocoupleur (5a, 5b), le signal de réglage (S_{F1}, S_{F2}) pour le régulateur de courant (12a, 12b) du second photocoupleur (5a, 5b) à partir du signal utile.
